# EUROPEAN PATENT APPLICATION

(11) **EP 3 709 515 A1**
(43) Date of publication of application: **16.09.2020**
(21) Application number: 19460019.3
(22) Date of filing: 15.04.2019
(51) Int. Cl.: H03K 17/96

(54) **PIEZOELECTRIC BUTTON**

(30) Priority: 12.03.2019 PL 42924119
(71) Applicant: AVIMOT SPÓLKA Z OGRANICZONA ODPOWIEDZIALNOSCIA, 38-400 Krosno (PL)
(72) Inventor: PIATEK, Piotr, 38-100 Strzyzów (PL)

(57) **Abstract**

The piezoelectric switch having an element using the piezoelectric effect is characterized in that it consists of the piezoelectric element 1 in a form of the metal base 2 and a layer of the piezoelectric 3 placed in a recess of the face of the housing 6 using the glue 4, that are shielded with a layer of the flexible material 7 and the rigid layer 8, and of the signal leads 9 going through the layers and connected to the piezoelectric element.

## Description

The subject of the invention is a piezoelectric button used in electronics to generate electric pulses, specifically for the underwater equipment, among others in the electronic navigational console.

A piezoelectric or piezoelectric material is a crystal showing the piezoelectric effect consisting in electric charges occurrence on its surface under the influence of mechanical stresses.

US5216316A shows a piezoelectric transducer having a servomotor fastened to a housing and covering the piezoelectric material located on two immovable contacts; its deformation by an actuator results in passage of current between the contacts.

Also, US6064141A shows a piezoelectric switch having a housing with a piezoelectric element mounted on its internal surface and connected to a printed-circuit board with a conductor.

An inconvenience of the solutions known so far from the state of the art is difficulty to obtain a completely hermetic solution without movable and mechanically connected elements.

The object of the invention is to work out a button construction to be used in electronics and able to operate while immersed completely in water or another liquid and gaseous media, that can be used in faces of device housings without any significant change of their overall dimensions and any necessity to make holes for buttons.
According to the invention, the essence of the piezoelectric switch consists in that it consists of a piezoelectric element in a form of a metal base and a piezoelectric layer placed in a recess of the housing face using glue, that are shielded with a layer of flexible material and a rigid layer, and of signal leads going through the layers and connected to the piezoelectric element. Preferably, the layer of the flexible material is made of silicone, polyurethane or another flexible material. Also preferably, the rigid layer is made of epoxide, polyurethane or another rigid material. Preferably as well, a spline to identify a button position easily and to increase sensitivity is located in the active area on the housing face. Preferably, its construction allows to operate while immersed completely in water or another liquid and gaseous media.

Thanks to use, in the solution according to the invention, of the piezoelectric element of small thickness, glued directly to the element housing face and properly stiffened at rest/inactiveness but with possibility of its deformation by pressure due to its location on the layer made of compressible material, it is possible to use the piezoelectric effect and generate the electric charge that can be processed, identified and used in any commonly known manner.

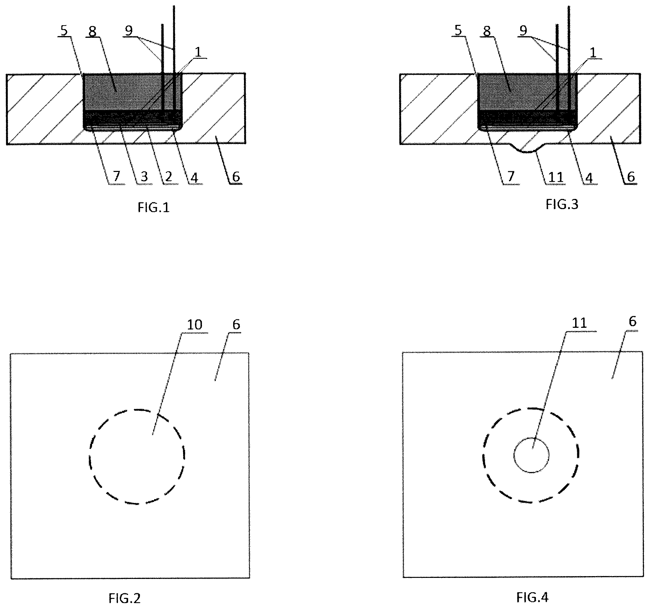

The subject of the invention is shown in two variants of its embodiment as follows: the Fig. 1 and 2 show the first switch embodiment where Fig. 1 shows the cross-section of the piezoelectric switch and the Fig. 2 shows the same switch as a view from the housing face side with the marked active area of the button whereas the Fig. 3 and 4 show the second switch embodiment with the spline where Fig. 3 shows the cross-section of the piezoelectric switch and the Fig. 4 shows the same switch as a view from the housing face side with the marked active area of the button.

According to the invention, the switch is the piezoelectric element 1 consisting of the metallic base 2, i.e. the round metallic plate, and the layer of the piezoelectric 3 connected to it where the piezoelectric is glued with the adhesive 4 in the cylindrical recess 5 of the face of the housing 6 of the device, made in its internal side. The piezoelectric element is shielded as a whole with the layer made of the flexible material 7, eg. silicone, and then shielded with the rigid layer 8 made of the rigid polyurethane, wherein the flexible material 5 together with the rigid layer 8 fill up the recess 5 tightly. Moreover, the signal leads 9 have been soldered or welded to the piezoelectric element 1 and they are sunken and go through the flexible material 7 and the rigid layer 8.

In the other button embodiments according to the invention, an additional bulge 11 has been created on the face of the housing 6 in the flat active area 10 located opposite to the piezoelectric element 1 to identify easily the button position and to increase the button sensitivity, whereas the polyurethane shielded with the rigid layer 8 made of epoxide was used as the flexible material 7.

In all of the embodiments, the metallic bases 2 under the layer of the piezoelectric 3 are the typical metals used together with piezoelectrics, eg. in a form of brass plates. A ready piezoelectric element commonly used eg. in sound signal units can be used as the piezoelectric element 1.

The principle of operation of the button according to the invention consists in that after pressing the active area 10 or the bulge 11, a small deformation of the active area occurs on the external face of the housing 6 and this results in deformation of the piezoelectric element 1 inside the cylindrical recess 5. As the result of deformation in the piezoelectric element 1, the piezoelectric effect occurs that generates an electric pulse transferred through the signal leads 9 to further devices connected to them and using / processing this pulse.

## Claims

1. A piezoelectric switch having an element using the piezoelectric effect, **characterized in that** it consists of a piezoelectric element (1) in a form of a metal base (2) and a layer of a piezoelectric (3) placed in a recess (5) of the face of a housing (6) using a glue (4), that are shielded with a layer of a flexible material (7) and a rigid layer (8), and of signal leads (9) going through the layers and connected to the piezoelectric element.

2. The piezoelectric switch according to the claim 1, **characterised in that** the layer of the flexible material (7) is made of silicone, polyurethane or another flexible material.

3. The piezoelectric switch according to the claim 1, **characterised in that** the rigid layer (8) is made of epoxide, polyurethane or another rigid material.

4. The piezoelectric switch according to the claim 1, **characterised in that** it has a spline (11) to identify the button position easily and to increase sensitivity located in the active area (10) on the face of the housing (6).

5. The piezoelectric switch according to the claim 1, **characterised in that** its construction allows operation while immersed completely in water or another liquid and gaseous media.
